(19) Europäisches Patentamt
European Patent Office
Office européen des brevets

(11) **EP 3 595 178 B1**

(12) **EUROPEAN PATENT SPECIFICATION**

(45) Date of publication and mention
of the grant of the patent:
**06.04.2022 Bulletin 2022/14**

(21) Application number: **18182472.3**

(22) Date of filing: **09.07.2018**

(51) International Patent Classification (IPC):
*H03M 3/04* (2006.01)   *H03M 1/60* (2006.01)

(52) Cooperative Patent Classification (CPC):
**H03M 3/428; H03M 1/60; H03M 3/414**

(54) **CONTINUOUS TIME SIGMA DELTA MODULATOR**

ZEITKONTINUIERLICHER SIGMA-DELTA-MODULATOR

MODULATEUR DE SIGMA DELTA EN DURÉE CONTINUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.01.2020 Bulletin 2020/03**

(73) Proprietor: **MaxLinear Asia Singapore Private
Limited
Singapore (SG)**

(72) Inventors:
• **Di Giandomenico, Antonia
9524 Villach (AT)**
• **Hernandez, Luis
28039 Madrid (ES)**
• **Fernandez-Gutierrez, Eric
28911 Madrid (ES)**
• **Paton-Alvarez, Susana
28911 Leganes Madrid (ES)**

(74) Representative: **2SPL Patentanwälte PartG mbB
Landaubogen 3
81373 München (DE)**

(56) References cited:
**US-A1- 2012 112 936**

• **QUINTERO A ET AL: "VCO-based ADC with a
simplified DAC for non-linearity correction",
ELECTRONICS LETTERS, IEE STEVENAGE, GB,
vol. 54, no. 13, 28 June 2018 (2018-06-28) , pages
813-815, XP006067905, ISSN: 0013-5194, DOI:
10.1049/EL.2018.1000**
• **YUAN FEI ED - RODRÍGUEZ VÁZQUEZ ÁNGEL ET
AL: "Design techniques for time-mode
noise-shaping analog-to-digital converters: a
state-of-the-art review", ANALOG INTEGRATED
CIRCUITS AND SIGNAL PROCESSING,
SPRINGER NEW YORK LLC, US, vol. 79, no. 2, 27
February 2014 (2014-02-27), pages 191-206,
XP035311671, ISSN: 0925-1030, DOI:
10.1007/S10470-014-0271-7 [retrieved on
2014-02-27]**

## Description

### Field

The present invention relates to a continuous time sigma delta modulator with a split voltage-controlled oscillator (VCO) quantizer.

### Background

Sigma delta modulators are widely used for analog-to-digital (A/D) conversion and digital-to-analog (D/A) conversion, etc. Generally, in sigma delta modulators an input signal is introduced into a loop filter, and quantized by a quantizer, and then processed through digital filters. In order to compensate for the errors a feedback signal is sent back via a digital-to-analog converter (DAC) to be subtracted from the input signal before entering the quantizer.

The performance of open-loop analog-to-digital converters (ADCs) implemented with VCO-based quantizer is limited by VCO non-linearity and first-order noise shaping. The resolution limitation imposed by first-order noise shaping can be compensated by a ring oscillator VCO with many output phases. Linearity can also be improved by using a feedback loop around the VCO closed with a DAC. However, a long ring oscillator may require a DAC with a prohibitive number of bits if feedback is used to compensate distortion.

Quintero et al.: "VCO-based ADC with a simplified DAC for non-linearity correction", Electronics Letters, vol. 54, no. 13, 28 June 2018 discloses a VCO-based ADC. Quintero et al. discloses a VCO-ADC architecture that permits to implement a high-resolution VCO quantizer with sufficient linearity using a feedback DAC with a reduced number of output levels. Quintero et al. discloses that first-order noise-shaped VCO-based ADCs can be built either with open-loop or closed-loop pseudo-differential configurations, and in both cases, an ideal counter performs the integration of the VCO's phase by counting the edges of the output square wave.

US 2012/112936 is related to quantization circuit having a VCO-based quantizer compensated in a phase domain. US 2012/112936 discloses a continuous-time delta-sigma analog-to-digital converter with a feedback loop.

Yuan Fei, "Design techniques for time-mode noise-shaping analog-to-digital converters: a state-of-the-art review", Analog Integrated Circuits and Signal Processing, vol. 79, no. 2, 27 February 2014 discloses a detailed investigation of closed-loop time-mode noise-shaping ADCs with an emphasis on techniques combating the effect of the nonlinear voltage-to-phase characteristics of VCO quantizers and the effect of the nonlinearity of internal DACs.

### Brief description of the Figures

Some examples of apparatuses and/or methods will be described in the following by way of example only, and with reference to the accompanying figures, in which

Fig. 1 shows an example structure of a sigma delta modulator in accordance with one example;

Fig. 2 shows a structure of an example 2-0 multi-stage noise shaping (MASH) VCO-based continuous time sigma delta modulator in accordance with one example;

Fig. 3 shows a more detailed structure of the example continuous time sigma delta modulator of Fig. 2 in accordance with one example;

Fig. 4 shows the fast Fourier transform (FFT) spectrum of the first stage and of the whole 2-0 MASH VCO-based sigma delta modulator;

Fig. 5 is a flow diagram of a process for modulating an input signal with a sigma delta modulator in accordance with one example;

Fig. 6 illustrates a user device in which the examples disclosed herein may be implemented;

Fig. 7 illustrates a base station or infrastructure equipment radio head in which the examples disclosed herein may be implemented; and

Fig. 8 shows an equivalent single-ended discrete linear model of the example sigma delta modulators of Figs. 1-3.

**Detailed Description**

According to an aspect, there is provided a continuous-time sigma delta modulator, as defined in the appended independent claim 1. According to another aspect, there is provided a method for modulating an input signal with a continuous-time sigma delta modulator, as defined in the appended independent claim 4. Further features according to embodiments are defined in the appended dependent claims.

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

Examples are disclosed for a VCO-based continuous time sigma delta modulator. A VCO-based continuous time sigma delta modulator is an efficient architecture as compared to a conventional continuous time sigma delta modulator with flash quantizer, since it eases the implementation of the analog-to-digital conversion inside the loop. However, the conventional VCO-based sigma delta modulator does not solve the problem of efficient digital-to-analog conversion when multiple levels are used to achieve a higher signal-to-noise ratio (SNR) and/or a lower over-sampling ratio (OSR). The examples disclosed herein can increase the number of bits of the VCO-based closed-loop continuous time sigma delta modulator to achieve sufficient SNR even with low OSR to implement, for example, analog bandwidth in excess of 100 MHz by a split N-0 MASH architecture while still maintaining a reduced number of bits in the feedback DAC.

Conventional continuous time sigma delta modulators with a VCO-based ADC require a hard-to-implement multi-level DAC in order to benefit from a multibit first order configuration, which is less efficient. The target of the feedback is to improve the linearity of the ADC. Previous N-0 MASH sigma delta architectures have been disclosed either for classical discrete-time analog filter implementations with power hungry flash quantizers or for counter-based VCO ADCs without a continuous time filter in the loop. The conventional systems have disadvantages of a large size of flash quantizers, a low power efficiency of a multi-level feedback DAC, and a low sampling rate and low SNR that can be achieved by using counter-based VCO ADC without an analog filter in the loop.

In the example continuous time sigma delta modulator disclosed herein, the digital output lines of the VCO-based quantizer are split and a portion of them (N bits out of M output bits) are sent to the DAC, while others (M-N bits) are sent to a feedforward digital error correction filter which recovers the full SNR achievable if all of them were sent to the feedback DAC.

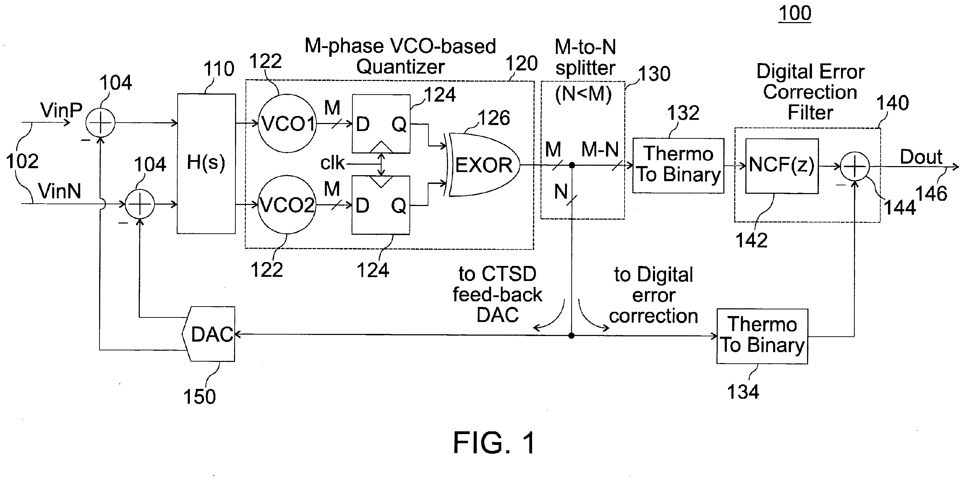

Fig. 1 shows an example structure of a sigma delta modulator 100 in accordance with one example. The sigma delta modulator 100 includes a loop filter 110, an oscillator-based quantizer 120, an M-to-N splitter 130, a digital error correction filter 140, and a DAC 150. In the example, the oscillator-based quantizer 120 also works as an integrator.

The input analog signal 102 (e.g. a differential signal) is filtered through the loop filter 110. The loop filter 110 provides a gain for the sigma delta modulator which attenuates the quantization errors in the band of interest. For example, the loop filter 110 may be an integrator (e.g. a first or higher order integrator). The loop filter 110 may be approximated as being a cascade of integrator stages and the transfer function of an N-th order loop filter may be

expressed as: $H(s) = \left(\dfrac{f_s}{s}\right)^N$ , where $f_s$ is the sampling frequency. When the loop filter 110 includes a cascade of integrators, the quantization noise is high-pass filtered and is thus attenuated or shaped in the band of interest due to the gain provided by the loop filter.

The oscillator-based quantizer 120 (e.g. a VCO-based quantizer) converts the loop filter output to a digital signal (an M-bit digital signal). The oscillator-based quantizer 120 includes a VCO(s) 122. Assuming a linear VCO, the output of the VCO 122 is a frequency-domain signal approximating the input signal 102. The phase progression of the VCO 122 is tracked. The VCO output is sampled with a register 124 triggered by the sampling clock. The resulting sample sequence is differentiated in the digital domain to retrieve the frequency information from the sampled phase.

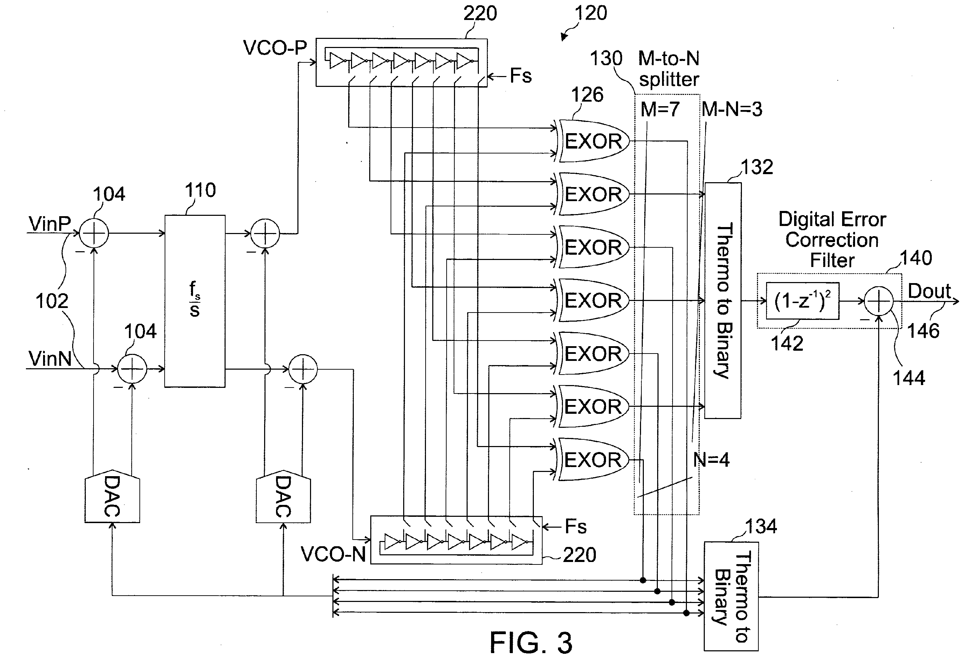

The VCO 122 is implemented with a ring oscillator. The details of the ring oscillator will be explained with reference to Fig. 3. A ring oscillator is a device composed of a number of inverters in a ring, whose output oscillates between two voltage levels. The inverters are cascaded in a chain and the output of the last inverter is fed back to the first inverter in the chain. The ring oscillator outputs multi-phase signals, i.e. M bits, which may be latched into the register 124 by a sampling clock.

In some examples, as shown in Fig. 1, the quantizer 120 includes two VCOs 122 (e.g. two ring oscillators) arranged in a differential manner. Differential input signals 102 are filtered through the loop filter 110 and then fed into the two VCOs 122, respectively. Phase outputs of the two VCOs 122 are latched into two registers 124, respectively, and the phase of one VCO is compared with that of the other, e.g., with exclusive OR (XOR) gates 126 or subtractors.

Alternatively, instead of using two VCOs in a differential manner, a single-ended structure may be employed. In that case, the input signal enters into a single VCO (after filtered through the loop filter) and then two successive phase outputs of the VCO are compared each other with XOR gates.

The M-to-N splitter 130 splits the M bits output from the quantizer 120 into N bits and M-N bits. The N bits are sent to the DAC 150 in the feedback path and the M-N bits are sent to the digital error correction filter 140. In the feedback path, only the N bits out of the M bits are used in generating the feedback signal. The DAC 150 generates a feedback signal based on the N bits and the feedback signal is subtracted from the input signal 102 by the summing device 104. The DAC 150 may be a set of 1-bit DACs (N number of 1-bit DACs) or alternatively one or more multi-bit DAC(s). This scheme allows to exchange the analog complexity (i.e. simpler DAC design with a lower number of input bits) with digital filtering (additional error correction filtering needed), which is a great benefit in today's nanometer CMOS technologies.

The output bits from the splitter 130 (M-N bits and N bits) may be binary-coded by the thermo-to-binary coders 132, 134, respectively. The thermo-to-binary coders 132, 134 count the number of 1's output from the quantizer 120 and may encode the counted number to a binary number. The binary-coded bits of the M-N bits are processed through the noise cancellation filter (NCF) 142. The binary-coded bits of the N bits are then merged with the outputs from the noise cancellation filter 142 and output as a modulator output 146.

The digital error correction filter 140 needs to match the analog filter (i.e. the loop filter 110) that the digital loop sees. This works intrinsically better in the VCO-based approach since the built-in integrator is practically ideal (it is composed of digital logic gates), as compared to the conventional continuous-time sigma-delta implementations. As an example, if H(s) = 1 (i.e. there is no analog filter in the loop), then NCF(z) = 1 - $z^{-1}$, and if H(s) = first-order integrator, then NCF(z) = (1 - $z^{-1}$)$^2$. The noise cancellation filter 142 is adapted in accordance with the analog filter functions implemented in the loop filter 110.

The examples have advantages such that medium resolution ADCs may be used with bandwidth in excess of 100 MHz using mostly digital circuitry as the flash comparators, references and preamplifiers are replaced by a simpler ring oscillator with much less power and transistor count.

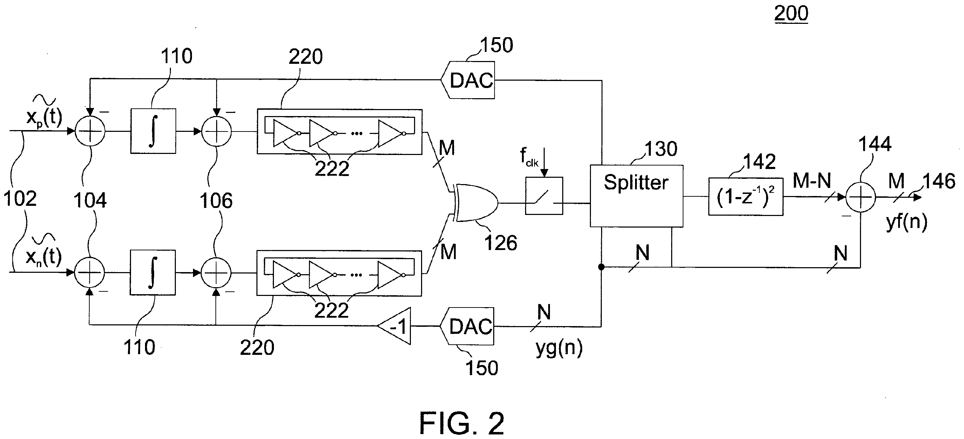

Fig. 2 shows a structure of an example 2-0 multi-stage noise shaping (MASH) VCO-based continuous time sigma delta modulator 200 in accordance with one example. The modulator 200 has a differential structure including two sets of ring oscillators 220 arranged in a differential manner. The phase outputs of the dual ring oscillators (VCOs) are measured by comparing the phase of one ring oscillator with that of the other. As explained above, a single-ended structure may be used as an alternative. The differential input signals 102 enter the modulator 200. The feedback signal from the DAC 150 is subtracted from the input signals 102 by the summing device 104 and then processed through the loop filter 110. The loop filter 110 may be an Op-amp based integrator. The feedback signal from the DAC 150 is subtracted from the loop filter outputs by the summing device 106 and then the resulting signal drives the ring oscillators 220.

Each ring oscillator 220 has a plurality of inverters 222 cascaded in a ring and generates M output phases (i.e. the phases of each constituent inverters 222). The M output phases from the two ring oscillators 220 are compared each other by a set of XOR gates 126. N out of the M output bits from the XOR gates 126 are used as feedback to the DAC 150. For example, the N phases for feedback to the DAC 150 may be chosen by selecting one phase and skipping the

following $\left(\left\lfloor\frac{M}{N}\right\rfloor - 1\right)$, where $\lfloor \cdot \rfloor$ is a floor function. In this way the N signals for the feedback are regularly spaced among all the ring oscillator outputs. Any integer numbers may be selected for the values of M and N (e.g. M=64 and N=16 (VCO rest oscillation ~700 MHz)).

Among the M output bits from the XOR gates 126, N bits (e.g. evenly distributed among M bits) are sent to the DAC 150. The DAC output is then subtracted from the input signal 102 by the summing device 104. The number of phases N used in the feedback is related to the distortion in the ring oscillator 220. The larger the N the smaller the input voltage to the ring oscillator 220 which helps to reduce the nonlinearity. However, it will increase the size of the DAC 150.

The M-N bits may be binary-coded by a thermo-to-binary encoder 132 and then sent to the digital error correction filter 140 (i.e. the noise cancellation filter 142), which performs the matching operation of the loop filter 110. The remaining N bits may be binary-coded by a thermo-to-binary encoder 134 and then merged with the outputs from the noise cancellation filter 142. The adder 144 indicates merging of the data lines. The merged bits are output as a modulator output 146.

Fig. 3 shows a more detailed structure of the example continuous time sigma delta modulator of Fig. 2 in accordance with one example. In this example, M=7 and N=4 are used just for illustration purposes, and any number can be selected for M and N. The loop filter 110 may be a first order integrator, a second order integrator, or a higher order integrator. Each ring oscillator 220 includes M inverters 222. M phases of the inverters 222 from each ring oscillator 220 may be sampled at the sampling frequency (Fs) and the outputs from the two ring oscillators 220 are compared each other by the XOR gates 126.

The ring oscillators 220 are arranged in a differential manner. The phase output of the quantizer 120 is measured by comparing the phase of one ring oscillator with that of the other. The integration and quantization is realized by the two ring oscillators 220 in the phase domain. The digital output from the quantizer 120 corresponds to phase difference between the two ring oscillators 220, which can be simply taken out by letting them refer to each other. The feedback loop helps to achieve a steady state where the phases of the two VCOs pursue with each other, making their phase difference to be coherent with the amplitude of the analog input signal. If the digital output from the quantizer 120 changes, a current on one ring oscillator decreases while a current on the other ring oscillator increases.

When inverters 222 are not flipping, their inputs and outputs are opposite. If there is an odd number of inverters 222 in the ring, one inverter has the same input and output and is in transition. This transitioning point indicates that the oscillator phase has propagated to that inverter.

Upon initial power up, the phase of the two ring oscillators 220 are placed at certain locations. One of the ring oscillator would lead the other. This relationship between the phases of the two ring oscillators 220 will determine the outputs of the XOR gates 126. The digital output which is the sum of all outputs of the XOR gates 126 will determine the amount of current draw from the two branches, which will determine the oscillation frequencies of the two oscillators 220. As a result, the phase difference between the two ring oscillators 220 changes until it reaches a stable state.

When the input changes, it speeds up one oscillator and slows down the other. What varies with the input is the phase difference between the two ring oscillators 220. The oscillator phase difference is proportional to the input. At every clock cycle, the phase difference is sampled and quantized. The digital output from the quantizer 120 is then processed through the noise cancellation filter 142.

From the M bits of the ring oscillator (corresponding to M phases), N bits are taken into the feedback and M-N bits are digitally post-processed with a digital filter 140 equivalent to the analog filter seen by the bits in the feedback. At the end, all the bits are combined into a multibit digital signal to improve the SNR and achieve the full SNR. The full SNR can be achieved, but using less bits in the feedback path and, consequently, simplifying the circuitry.

The M-N bits in feedback are included into the sigma delta loop, which means that they are filtered by the analog transfer function of the loop. The rest N bits need to see the same transfer function, but from a digital domain. In case of seeing the same function, when all the bits are combined the quantization noise of the output would be the same as if all the bits were included into the loop. Consequently, the expected SNR is the full one.

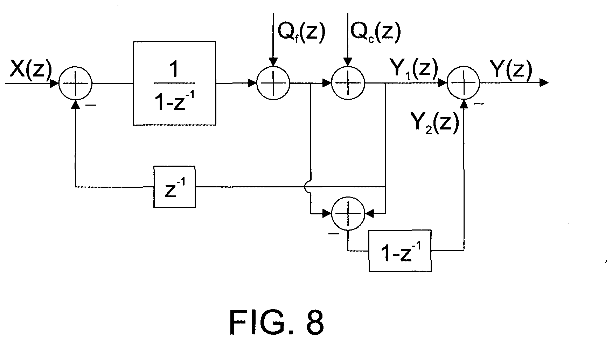

Fig. 8 shows an equivalent single-ended discrete linear model of the example sigma delta modulators of Figs. 1-3. Fig. 8 shows achieving the full SNR for the first order case. X(z) is the input, $Q_f$ represents the quantization error in case of taking all the bits into the loop, and $Q_c$ represents the quantization error in case taking only a portion. In equation (3) for Y(z), it is observed that $Q_c$ is removed and $Q_f$ remains, leading to the full SNR

$$Y_1(z) = (1 - z^{-1})\left(Q_f(z) + Q_c(z)\right) + X(z), \qquad \text{Equation (1)}$$

$$Y_2(z) = (1 - z^{-1})Q_c(z), \qquad \text{Equation (2)}$$

$$Y(z) = Y_1(z) - Y_2(z) = (1 - z^{-1})Q_f(z) + X(z).$$  Equation (3)

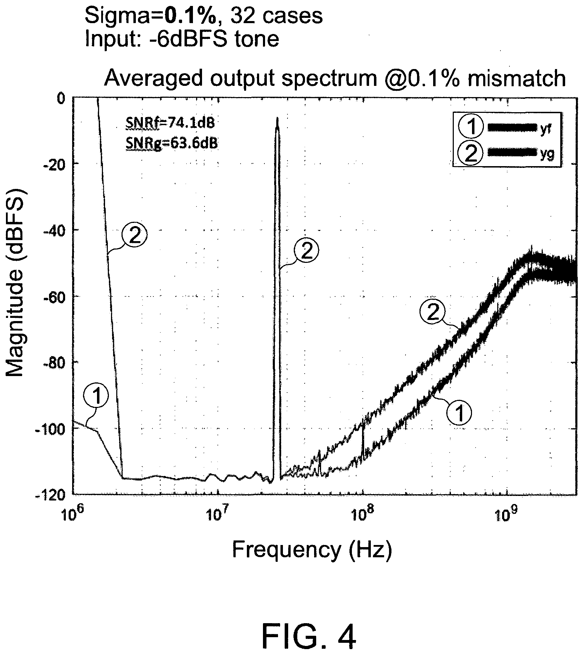

Fig. 4 shows a simulation result. Fig. 4 shows the fast Fourier transform (FFT) spectrum of the first stage (y(g) in Fig. 2) and of the whole 2-0 MASH VCO-based sigma delta modulator (y(f) in Fig. 2). Fig. 4 shows the impact of a typical non-ideality of the feedback DAC (mismatch between the unity elements) and of the VCO-nonlinearity to the overall performance. The DAC mismatch is mitigated by the implicit clocked averaging (CLA) property of the implementation (resulting in a slight increase of the in-band noise-floor), while the VCO non-linearity is attenuated by the loop filter. Fig. 4 shows a 9 dB SNR net improvement (from the first stage to the whole 2-0 MASH modulator output) with the implementation in accordance with the disclosed examples.

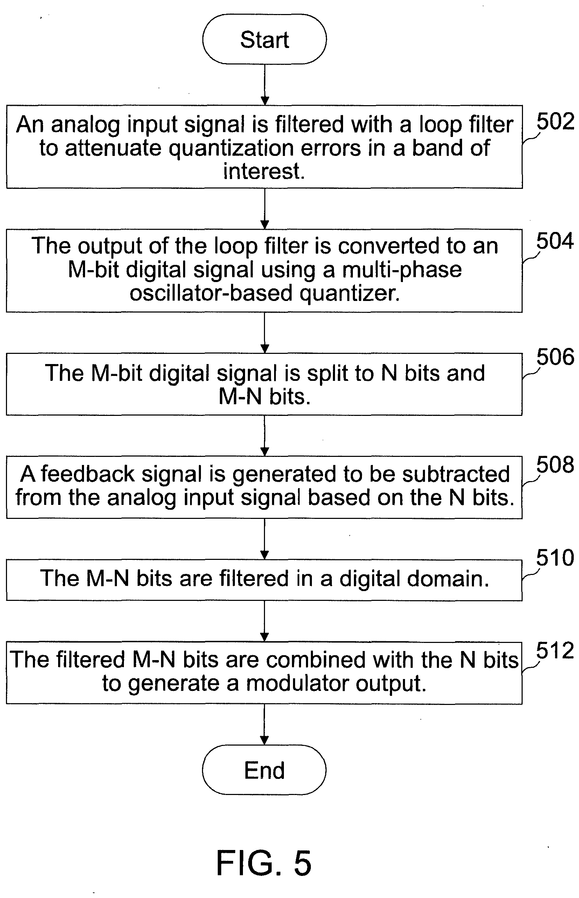

Fig. 5 is a flow diagram of a process for modulating an input signal with a sigma delta modulator in accordance with one example. An analog input signal is filtered with a loop filter to attenuate quantization errors in a band of interest (502). The output of the loop filter is converted to an M-bit digital signal using a multi-phase oscillator-based quantizer (504). The multi-phase oscillator-based quantizer includes a ring oscillator including a plurality of inverters cascaded in a ring and XOR gates configured to capture phase differences of the inverters. The input signal may be a differential signal and the multi-stage oscillator-based quantizer includes two ring oscillators and the XOR gates captures phase differences of the inverters of the two ring oscillators. The M-bit digital signal is split to N bits and M-N bits (506). A feedback signal is generated to be subtracted from the analog input signal based on the N bits (508). The M-N bits are filtered in a digital domain (510). The filtered M-N bits are combined with the N bits to generate a modulator output (512).

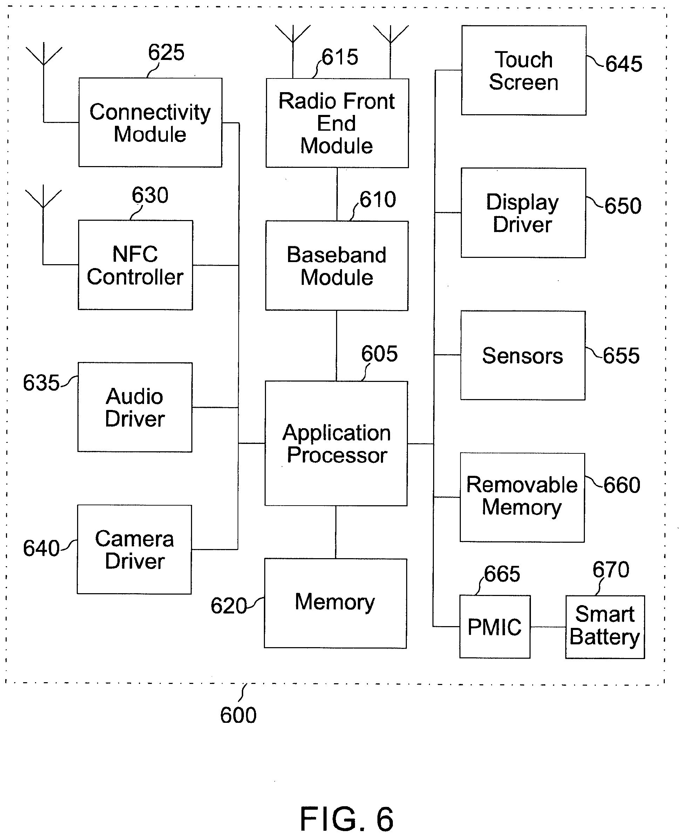

Fig. 6 illustrates a user device 600 in which the examples disclosed herein may be implemented. The user device 600 may be a mobile device in some aspects and includes an application processor 605, baseband processor 610 (also referred to as a baseband module), radio front end module (RFEM) 615, memory 620, connectivity module 625, near field communication (NFC) controller 630, audio driver 635, camera driver 640, touch screen 645, display driver 650, sensors 655, removable memory 660, power management integrated circuit (PMIC) 665 and smart battery 670.

In some aspects, application processor 605 may include, for example, one or more CPU cores and one or more of cache memory, low drop-out voltage regulators (LDOs), interrupt controllers, serial interfaces such as serial peripheral interface (SPI), inter-integrated circuit ($I^2C$) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 610 may be implemented, for example, as a solder-down substrate including one or more integrated circuits, a single packaged integrated circuit soldered to a main circuit board, and/or a multi-chip module containing two or more integrated circuits.

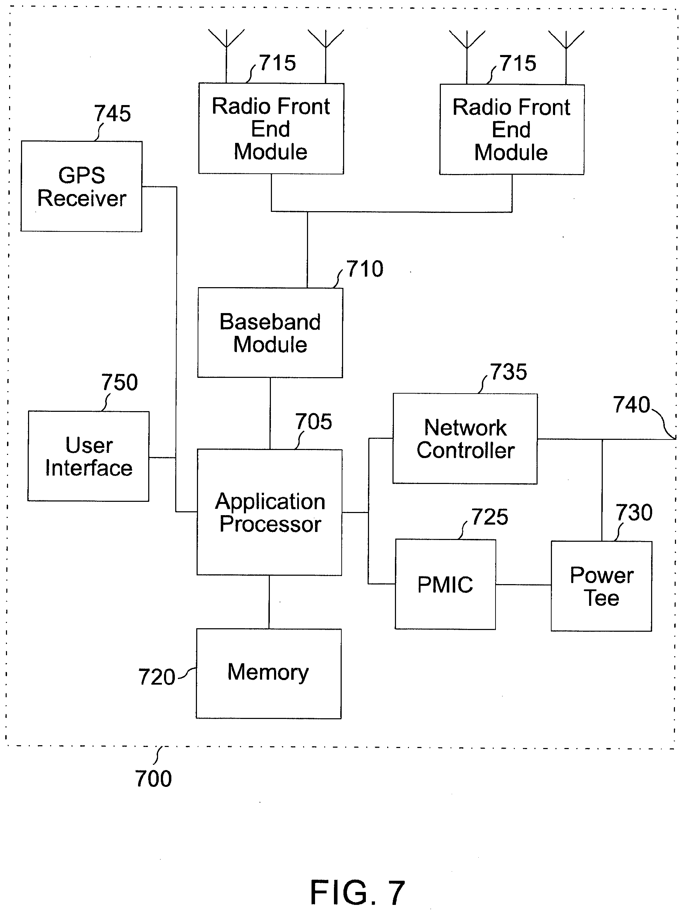

Fig. 7 illustrates a base station or infrastructure equipment radio head 700 in which the examples disclosed herein may be implemented. The base station radio head 700 may include one or more of application processor 705, baseband modules 710, one or more radio front end modules 715, memory 720, power management circuitry 725, power tee circuitry 730, network controller 735, network interface connector 740, satellite navigation receiver module 745, and user interface 750.

In some aspects, application processor 705 may include one or more CPU cores and one or more of cache memory, low drop-out voltage regulators (LDOs), interrupt controllers, serial interfaces such as SPI, $I^2C$ or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 710 may be implemented, for example, as a solder-down substrate including one or more integrated circuits, a single packaged integrated circuit soldered to a main circuit board or a multi-chip module containing two or more integrated circuits.

In some aspects, memory 720 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magneto resistive random access memory (MRAM) and/or a three-dimensional crosspoint memory. Memory 720 may be implemented as one or more of solder down packaged integrated circuits, socketed memory modules and plug-in memory cards.

In some aspects, power management integrated circuitry 725 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 730 may provide for electrical power drawn from a network cable to provide both power supply and data connectivity to the base station radio head 700 using a single cable.

In some aspects, network controller 735 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 745 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 745 may provide data to application processor 705 which may include one or more of position data or time data. Application processor 705 may use time data to synchronize operations with other radio base stations.

In some aspects, user interface 750 may include one or more of physical or virtual buttons, such as a reset button, one or more indicators such as light emitting diodes (LEDs) and a display screen.

Another example is a computer program having a program code for performing at least one of the methods described herein, when the computer program is executed on a computer, a processor, or a programmable hardware component. The following examples are not covered in their generality by the claims, but might help to understand the invention or might relate to optional features.

One example is a sigma delta modulator comprising a loop filter configured to filter an analog input signal to attenuate quantization errors in a band of interest, a multi-phase oscillator-based quantizer configured to convert an output of the loop filter to an M-bit digital signal, a splitter configured to split the M-bit digital signal to N bits and M-N bits, a DAC configured to generate a feedback signal to be subtracted from the analog input signal based on the N bits, and a digital error correction filter configured to filter the M-N bits and combine the filtered M-N bits with the N bits.

In some example, the multi-phase oscillator-based quantizer comprises a ring oscillator including a plurality of inverters cascaded in a ring, and an XOR gate configured to capture phase differences of the inverters.

In some example, the input signal is a differential signal and the multi-stage oscillator-based quantizer includes two ring oscillators and the XOR gate is configured to capture phase differences of the inverters of the two ring oscillators.

In some example, the loop filter is a multi-stage noise shaping filter.

In some example, the loop filter is a first-order integrator.

In some example, the digital error correction filter is configured to adapt a filter function based on a filter function implemented in the loop filter.

In some example, the N bits selected from the M bits are evenly distributed over the M bits.

Another example is a method for modulating an input signal with a sigma delta modulator. The method includes filtering an analog input signal with a loop filter to attenuate quantization errors in a band of interest, converting an output of the loop filter to an M-bit digital signal with a multi-phase oscillator-based quantizer, splitting the M-bit digital signal to N bits and M-N bits, generating a feedback signal to be subtracted from the analog input signal based on the N bits, filtering the M-N bits in a digital domain, and combining the filtered M-N bits with the N bits.

In some example, the multi-phase oscillator-based quantizer comprises a ring oscillator including a plurality of inverters cascaded in a ring, and an XOR gate configured to capture phase differences of the inverters.

In some example, the input signal is a differential signal and the multi-stage oscillator-based quantizer includes two ring oscillators and the XOR gate is configured to capture phase differences of the inverters of the two ring oscillators.

In some example, the loop filter is a multi-stage noise shaping filter.

In some example, the loop filter is a first-order integrator.

In some example, the filtering the M-N bits corresponds to a filter function implemented in the loop filter.

In some example, the N bits selected from the M bits are evenly distributed over the M bits.

Another example is a machine-readable storage including machine readable instructions, when executed, to implement a method or realize an apparatus as in any one of examples above.

Another example a sigma delta modulator. The sigma delta modulator includes a first means for filtering an analog input signal to attenuate quantization errors in a band of interest, a means for converting an output of the means for filtering to an M-bit digital signal, a means for splitting the M-bit digital signal to N bits and M-N bits, a means for generating a feedback signal to be subtracted from the analog input signal based on the N bits, and a second means for filtering the M-N bits and combining the filtered M-N bits with the N bits.

In some example, the means for converting includes a ring oscillator including a plurality of inverters cascaded in a ring, and an XOR gate configured to capture phase differences of the inverters.

In some example, the input signal is a differential signal and the means for converting includes two ring oscillators and the XOR gate is configured to capture phase differences of the inverters of the two ring oscillators.

In some example, the first means for filtering is a multi-stage noise shaping filter.

In some example, the first means for filter is a first-order integrator.

In some example, the second means for filtering is configured to adapt a filter function based on a filter function implemented in the first means for filtering.

In some example, the N bits selected from the M bits are evenly distributed over the M bits.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or-steps, respectively. Such sub acts may be included and part of the disclosure of this single act unless explicitly excluded.

Furthermore, the following claims are hereby incorporated into the detailed description.

## Claims

1. A continuous-time sigma delta modulator, comprising:

   a loop filter (110) configured to filter an analog input signal to attenuate quantization errors in a band of interest;
   a multi-phase oscillator-based quantizer (120) configured to convert an output of the loop filter (110) to an M-bit digital signal, wherein either the input signal is single-ended and the multi-phase oscillator-based quantizer (120) includes a voltage controlled oscillator, VCO, wherein the single-ended input signal filtered through the loop filter (110) is fed into the VCO, wherein the VCO comprises a single ring oscillator (220) including a plurality of inverters (222) cascaded in a ring, and exclusive OR, XOR, gates (126) configured to capture phase differences of two successive phase outputs of the inverters (222) to generate M phases corresponding to the M-bit digital signal, or
   the input signal is differential and the multi-phase oscillator-based quantizer (120) includes two VCOs arranged in a differential manner, wherein the differential input signal filtered through the loop filter (110) is fed into the two VCOs, respectively, wherein each VCO of the two VCOs comprises a ring oscillator, each ring oscillator including a plurality of inverters (222) cascaded in a ring, and XOR gates (126) configured to capture phase differences of the inverters (222) of the two ring oscillators to generate M phases corresponding to the M-bit digital signal representative of a phase difference between the two VCOs;

a splitter (130) configured to split the M-bit digital signal to N bits and M-N bits, wherein the N bits selected from the M bits are evenly distributed over the M bits;

a digital-to-analog converter, DAC, (150) configured to generate a feedback signal to be subtracted from the analog input signal based on the N bits; and

a digital error correction filter (140) configured to filter the M-N bits and combine the filtered M-N bits with the N bits, wherein the digital error correction filter (140) is configured to adapt a filter function based on a filter function implemented in the loop filter (110) in order to match the digital error correction filter (140) to the filter function of the loop filter (110).

2. The continuous-time sigma delta modulator of claim 1, wherein the loop filter (110) is a multi-stage noise shaping filter.

3. The continuous-time sigma delta modulator as in any one of claims 1-2, wherein the loop filter (110) is a first-order integrator.

4. A method for modulating an input signal with a continuous-time sigma delta modulator, the method comprising:

filtering (502) an analog input signal with a loop filter (110) to attenuate quantization errors in a band of interest;
converting (504) an output of the loop filter to an M-bit digital signal with a multi-phase ring oscillator-based quantizer (120), wherein either the input signal is single-ended and the multi-phase oscillator-based quantizer (120) includes a voltage controlled oscillator, VCO, wherein the single-ended input signal filtered through the loop filter (110) is fed into the VCO, wherein the VCO comprises a single ring oscillator (220) including a plurality of inverters (222) cascaded in a ring, and exclusive OR, XOR, gates (126) configured to capture phase differences of two successive phase outputs of the inverters (222) to generate M phases corresponding to the M-bit digital signal, or
the input signal is differential and the multi-phase oscillator-based quantizer (120) includes two VCOs arranged in a differential manner, wherein the differential input signal filtered through the loop filter (110) is fed into the two VCOs, respectively, wherein each VCO of the two VCOs comprises a ring oscillator, each ring oscillator including a plurality of inverters (222) cascaded in a ring, and XOR gates (126) configured to capture phase differences of the inverters (222) of the two ring oscillators to generate M phases corresponding to the M-bit digital signal representative of a phase difference between the two VCOs;
splitting (506) the M-bit digital signal to N bits and M-N bits, wherein the N bits selected from the M bits are evenly distributed over the M bits;
generating (508) a feedback signal to be subtracted from the analog input signal based on the N bits;
filtering (510), by a digital error correction filter (140), the M-N bits in a digital domain; and
combining (512) the filtered M-N bits with the N bits, wherein a filter function of the digital error correction filter (140) is adapted based on a filter function implemented in the loop filter (110) to match the digital error correction filter (140) to the filter function of the loop filter (110).

5. The method of claim 4, wherein the loop filter is a multi-stage noise shaping filter.

6. The method as in any one of claims 4-5, wherein the loop filter is a first-order integrator.

7. A computer program having a program code for performing the method of one of the claims 4-6.

**Patentansprüche**

1. Ein Kontinuierliche-Zeit-Sigma-Delta-Modulator, umfassend:

ein Schleifenfilter (110), das ausgebildet ist, um ein analoges Eingangssignal zu filtern, um Quantisierungsfehler in einem interessierenden Band zu dämpfen;
einen mehrphasigen oszillatorbasierten Quantisierer (120), der ausgebildet ist, um eine Ausgabe des Schleifenfilters (110) in ein digitales M-Bit-Signal umzuwandeln, wobei entweder das Eingangssignal asymmetrisch ist und der mehrphasige oszillatorbasierte Quantisierer (120) einen spannungsgesteuerten Oszillator, VCO, umfasst, wobei das asymmetrische Eingangssignal, das durch das Schleifenfilter (110) gefiltert wird, in den VCO eingespeist wird, wobei der VCO einen einzelnen Ringoszillator (220) umfasst, der eine Mehrzahl von Invertern (222), die in einem Ring kaskadiert sind, und Exklusives-ODER-, XOR, Gates (126) umfasst, die ausgebildet sind, um Phasendifferenzen von zwei aufeinanderfolgenden Phasenausgängen der Inverter (222) zu erfassen, um M Phasen zu erzeugen, die dem digitalen M-Bit-Signal entsprechen, oder

das Eingangssignal differenziell ist und der mehrphasige oszillatorbasierte Quantisierer (120) zwei VCOs umfasst, die in einer differenziellen Weise angeordnet sind, wobei das differenzielle Eingangssignal, das durch das Schleifenfilter (110) gefiltert wird, jeweils in die zwei VCOs eingespeist wird, wobei jeder VCO der zwei VCOs einen Ringoszillator umfasst, wobei jeder Ringoszillator eine Mehrzahl von Invertern (222), die in einem Ring kaskadiert sind, und XOR-Gates (126) umfasst, die ausgebildet sind, um Phasendifferenzen der Inverter (222) der zwei Ringoszillatoren zu erfassen, um M Phasen zu erzeugen, die dem digitalen M-Bit-Signal entsprechen, das eine Phasendifferenz zwischen den zwei VCOs darstellt;

einen Splitter (130), der ausgebildet ist, um das digitale M-Bit-Signal in N Bits und M-N Bits zu splitten, wobei die aus den M Bits ausgewählten N Bits gleichmäßig über die M Bits verteilt sind;

einen Digital-zu-Analog-Wandler, DAC, (150), der ausgebildet ist, um ein von dem analogen Eingangssignal basierend auf den N Bits zu subtrahierendes Rückkopplungssignal zu erzeugen; und

ein digitales Fehlerkorrekturfilter (140), das ausgebildet ist, um die M-N Bits zu filtern und die gefilterten M-N Bits mit den N Bits zu kombinieren, wobei das digitale Fehlerkorrekturfilter (140) ausgebildet ist, um eine Filterfunktion basierend auf einer in dem Schleifenfilter (110) implementierten Filterfunktion anzupassen, um das digitale Fehlerkorrekturfilter (140) auf die Filterfunktion des Schleifenfilters (110) abzustimmen.

2. Der Kontinuierliche-Zeit-Sigma-Delta-Modulator gemäß Anspruch 1, wobei das Schleifenfilter (110) ein mehrstufiges Rauschformungsfilter ist.

3. Der Kontinuierliche-Zeit-Sigma-Delta-Modulator gemäß einem der Ansprüche 1-2, wobei das Schleifenfilter (110) ein Integrator erster Ordnung ist.

4. Ein Verfahren zum Modulieren eines Eingangssignals mit einem Kontinuierliche-Zeit-Sigma-Delta-Modulator, das Verfahren umfassend:

Filtern (502) eines analogen Eingangssignals mit einem Schleifenfilter (110) zur Dämpfung von Quantisierungsfehlern in einem interessierenden Band;

Umwandeln (504) einer Ausgabe des Schleifenfilters in ein digitales M-Bit-Signal mit einem mehrphasigen ringoszillatorbasierten Quantisierer (120), wobei entweder das Eingangssignal asymmetrisch ist und der mehrphasige oszillatorbasierte Quantisierer (120) einen spannungsgesteuerten Oszillator, VCO, umfasst, wobei das asymmetrische Eingangssignal, das durch das Schleifenfilter (110) gefiltert wird, in den VCO eingespeist wird, wobei der VCO einen einzelnen Ringoszillator (220) umfasst, der eine Mehrzahl von Invertern (222), die in einem Ring kaskadiert sind, und Exklusives-ODER-, XOR, Gates (126) umfasst, die ausgebildet sind, um Phasendifferenzen von zwei aufeinanderfolgenden Phasenausgängen der Inverter (222) zu erfassen, um M Phasen zu erzeugen, die dem digitalen M-Bit-Signal entsprechen, oder

das Eingangssignal differenziell ist und der mehrphasige oszillatorbasierte Quantisierer (120) zwei VCOs umfasst, die in einer differenziellen Weise angeordnet sind, wobei das differenzielle Eingangssignal, das durch das Schleifenfilter (110) gefiltert wird, jeweils in die zwei VCOs eingespeist wird, wobei jeder VCO der zwei VCOs einen Ringoszillator umfasst, wobei jeder Ringoszillator eine Mehrzahl von Invertern (222), die in einem Ring kaskadiert sind, und XOR-Gates (126) umfasst, die ausgebildet sind, um Phasendifferenzen der Inverter (222) der zwei Ringoszillatoren zu erfassen, um M Phasen zu erzeugen, die dem digitalen M-Bit-Signal entsprechen, das eine Phasendifferenz zwischen den zwei VCOs darstellt;

Splitten (506) des digitalen M-Bit-Signals in N Bits und M-N Bits, wobei die aus den M Bits ausgewählten N Bits gleichmäßig über die M Bits verteilt sind;

Erzeugen (508) eines von dem analogen Eingangssignal basierend auf den N Bits zu subtrahierenden Rückkopplungssignals;

Filtern (510), durch ein digitales Fehlerkorrekturfilter (140), der M-N Bits in einem digitalen Bereich; und

Kombinieren (512) der gefilterten M-N Bits mit den N Bits, wobei eine Filterfunktion des digitalen Fehlerkorrekturfilters (140) basierend auf einer Filterfunktion angepasst wird, die in dem Schleifenfilter (110) implementiert ist, um das digitale Fehlerkorrekturfilter (140) auf die Filterfunktion des Schleifenfilters (110) abzustimmen.

5. Der Verfahren gemäß Anspruch 4, wobei das Schleifenfilter ein mehrstufiges Rauschformungsfilter ist.

**6.** Das Verfahren gemäß einem der Ansprüche 4-5, wobei das Schleifenfilter ein Integrator erster Ordnung ist.

**7.** Ein Computerprogramm mit einem Programmcode zum Durchführen des Verfahrens gemäß einem der Ansprüche 4-6.

**Revendications**

**1.** Modulateur sigma-delta à temps continu, comprenant :

un filtre de boucle (110) configuré pour filtrer un signal d'entrée analogique afin d'atténuer des erreurs de quantification dans une bande d'intérêt ;
un quantificateur polyphasé à base d'oscillateur (120) configuré pour convertir une sortie du filtre de boucle (110) en un signal numérique à M bits, dans lequel soit le signal d'entrée est asymétrique et le quantificateur polyphasé à base d'oscillateur (120) comprend un oscillateur commandé par tension, VCO, le signal d'entrée asymétrique filtré à travers le filtre de boucle (110) étant introduit dans le VCO, le VCO comprenant un oscillateur en anneau (220) unique comprenant une pluralité d'onduleurs (222) montés en cascade dans un anneau, et des portes OU exclusif, XOR, (126) configurées pour capturer des différences de phase de deux sorties de phase successives des onduleurs (222) pour générer M phases correspondant au signal numérique à M bits, soit le signal d'entrée est différentiel et le quantificateur polyphasé à base d'oscillateur (120) comprend deux VCO disposés de manière différentielle, le signal d'entrée différentiel filtré à travers le filtre de boucle (110) étant introduit dans les deux VCO, respectivement, chaque VCO des deux VCO comprenant un oscillateur en anneau, chaque oscillateur en anneau comprenant une pluralité d'onduleurs (222) montés en cascade dans un anneau, et des portes XOR (126) configurées pour capturer des différences de phase des onduleurs (222) des deux oscillateurs en anneau pour générer M phases correspondant au signal numérique à M bits représentatif d'une différence de phase entre les deux VCO ;
un diviseur (130) configuré pour diviser le signal numérique à M bits en N bits et M-N bits, les N bits sélectionnés parmi les M bits étant répartis uniformément sur les M bits ;
un convertisseur numérique-analogique, DAC, (150) configuré pour générer un signal de rétroaction à soustraire du signal d'entrée analogique sur la base des N bits ; et
un filtre de correction d'erreur numérique (140) configuré pour filtrer les M-N bits et combiner les M-N bits filtrés avec les N bits, le filtre de correction d'erreur numérique (140) étant configuré pour adapter une fonction de filtre sur la base d'une fonction de filtre implémentée dans le filtre de boucle (110) afin de faire correspondre le filtre de correction d'erreur numérique (140) à la fonction de filtre du filtre de boucle (110).

**2.** Modulateur sigma-delta à temps continu selon la revendication 1, le filtre de boucle (110) étant un filtre de mise en forme de bruit à plusieurs étages.

**3.** Modulateur sigma-delta à temps continu selon l'une des revendications 1-2, le filtre de boucle (110) étant un intégrateur de premier ordre.

**4.** Procédé pour moduler un signal d'entrée avec un modulateur sigma-delta à temps continu, le procédé comprenant :

filtrer (502) un signal d'entrée analogique avec un filtre de boucle (110) pour atténuer des erreurs de quantification dans une bande d'intérêt ;
convertir (504) une sortie du filtre de boucle en un signal numérique à M bits avec un quantificateur polyphasé à base d'oscillateur en anneau (120), dans lequel soit le signal d'entrée est asymétrique et le quantificateur polyphasé à base d'oscillateur (120) comprend un oscillateur commandé par tension, VCO, le signal d'entrée asymétrique filtré à travers le filtre de boucle (110) étant introduit dans le VCO, le VCO comprenant un oscillateur en anneau (220) unique comprenant une pluralité d'onduleurs (222) montés en cascade dans un anneau, et des portes OU exclusif, XOR, (126) configurées pour capturer des différences de phase de deux sorties de phase successives des onduleurs (222) pour générer M phases correspondant au signal numérique à M bits, soit le signal d'entrée est différentiel et le quantificateur polyphasé à base d'oscillateur (120) comprend deux VCO disposés de manière différentielle, le signal d'entrée différentiel filtré à travers le filtre de boucle (110) étant introduit dans les deux VCO, respectivement, chaque VCO des deux VCO comprenant un oscillateur en anneau, chaque oscillateur en anneau comprenant une pluralité d'onduleurs (222) montés en cascade dans un anneau, et des portes XOR (126) configurées pour capturer des différences de phase des onduleurs (222) des deux oscillateurs en anneau pour générer M phases correspondant au signal numérique à M bits représentatif d'une différence de phase entre les deux VCO ;

diviser (506) le signal numérique à M bits en N bits et M-N bits, les N bits sélectionnés parmi les M bits étant répartis uniformément sur les M bits ;

générer (508) un signal de rétroaction à soustraire du signal d'entrée analogique sur la base des N bits ;

filtrer (510), par un filtre de correction d'erreur numérique (140), les M-N bits dans un domaine numérique ; et combiner (512) les M-N bits filtrés avec les N bits, une fonction de filtre du filtre de correction d'erreur numérique (140) étant adaptée sur la base d'une fonction de filtre implémentée dans le filtre de boucle (110) afin de faire correspondre le filtre de correction d'erreur numérique (140) à la fonction de filtre du filtre de boucle (110).

5. Procédé selon la revendication 4, le filtre de boucle étant un filtre de mise en forme de bruit à plusieurs étages.

6. Procédé selon l'une des revendications 4-5, le filtre de boucle étant un intégrateur de premier ordre.

7. Programme d'ordinateur ayant un code de programme pour réaliser le procédé selon l'une des revendications 4-6.

FIG. 1

EP 3 595 178 B1

FIG. 2

FIG. 3

EP 3 595 178 B1

FIG. 4

```
                    ┌─────────┐
                    │  Start  │
                    └─────────┘
                         │
                         ▼
┌──────────────────────────────────────────────┐  502
│  An analog input signal is filtered with a   │
│  loop filter to attenuate quantization       │
│  errors in a band of interest.               │
└──────────────────────────────────────────────┘
                         │
                         ▼
┌──────────────────────────────────────────────┐  504
│  The output of the loop filter is converted  │
│  to an M-bit digital signal using a          │
│  multi-phase oscillator-based quantizer.     │
└──────────────────────────────────────────────┘
                         │
                         ▼
┌──────────────────────────────────────────────┐  506
│  The M-bit digital signal is split to N bits │
│  and M-N bits.                               │
└──────────────────────────────────────────────┘
                         │
                         ▼
┌──────────────────────────────────────────────┐  508
│  A feedback signal is generated to be        │
│  subtracted from the analog input signal     │
│  based on the N bits.                        │
└──────────────────────────────────────────────┘
                         │
                         ▼
┌──────────────────────────────────────────────┐  510
│  The M-N bits are filtered in a digital      │
│  domain.                                     │
└──────────────────────────────────────────────┘
                         │
                         ▼
┌──────────────────────────────────────────────┐  512
│  The filtered M-N bits are combined with the │
│  N bits to generate a modulator output.      │
└──────────────────────────────────────────────┘
                         │
                         ▼
                    ┌─────────┐
                    │   End   │
                    └─────────┘
```

# FIG. 5

FIG. 6

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• US 2012112936 A

### Non-patent literature cited in the description

• **QUINTERO et al.** VCO-based ADC with a simplified DAC for non-linearity correction. *Electronics Letters,* 28 June 2018, vol. 54 (13

• **YUAN FEI.** Design techniques for time-mode noise-shaping analog-to-digital converters: a state-of-the-art review. *Analog Integrated Circuits and Signal Processing,* 27 February 2014, vol. 79 (2